# EUROPEAN PATENT APPLICATION

(11) **EP 4 318 809 A1**
(43) Date of publication of application: **07.02.2024**
(21) Application number: 22780424.2
(22) Date of filing: 23.03.2022
(51) Int. Cl.: H01Q 15/14

(54) **HIGH FREQUENCY DIFFUSION SHEET**

(30) Priority: 29.03.2021 JP 2021056247
(71) Applicant: Sumitomo Bakelite Co., Ltd., Shinagawa-ku Tokyo 140-0002 (JP)
(72) Inventor: WATANABE, Toshiaki, Tokyo 140-0002 (JP); HOSOMI, Takeshi, Tokyo 140-0002 (JP)
(74) Representative: Ter Meer Steinmeister & Partner
(86) International application number: PCT/JP2022/013710
(87) International publication number: WO 2022/210210

(57) **Abstract**

A high frequency diffusion sheet 10 of the present invention is used for diffusing electromagnetic waves of a high frequency range and has an electromagnetic wave shielding layer 11 having electromagnetic wave shielding properties, in which the electromagnetic wave shielding layer 11 is patterned when seen in a plan view of the high frequency diffusion sheet 10, and has an opening portion 15 penetrating in a thickness direction of the electromagnetic wave shielding layer 11.

## Description

### TECHNICAL FIELD

The present invention relates to a high frequency diffusion sheet.

### BACKGROUND ART

In recent years, with the increase in speed and capacity of communication devices such as mobile phones, smartphones, tablets, and mobile personal computers, electromagnetic waves in a high frequency range of equal to or more than 1 GHz and equal to or less than 80 GHz have been proposed to be used as the electromagnetic waves (electromagnetic signals) received by these communication devices (refer to Patent Document 1, for example).

Electromagnetic waves in such a high frequency range have higher straightness (directivity) as compared to electromagnetic waves in a low frequency range. Therefore, when electromagnetic waves are received by a communication device inside a building, the electromagnetic waves, which have been transmitted through transmissive regions such as window parts through which the electromagnetic waves are allowed to be transmitted, are not diffused, that is, are not diffracted, and as a result, there arises a problem in that it becomes impossible to favorably receive electromagnetic waves over a wide area inside a building.

### RELATED DOCUMENT

### PATENT DOCUMENT

[Patent Document 1] Japanese Laid-Open Patent Publication No. 2012-190920

### SUMMARY OF THE INVENTION

### TECHNICAL PROBLEM

An object of the present invention is to provide a high frequency diffusion sheet that enables communication devices to favorably receive electromagnetic waves over a wide area inside a building even in the case of electromagnetic waves of a high frequency range by diffusing the electromagnetic waves of the high frequency range.

### SOLUTION TO PROBLEM

Such an object is achieved by the present invention described in the following (1) to (10).
(1) A high frequency diffusion sheet which is used for diffusing electromagnetic waves of a high frequency range, the high frequency diffusion sheet having: an electromagnetic wave shielding layer having electromagnetic wave shielding properties,
   in which the electromagnetic wave shielding layer is patterned when seen in a plan view of the high frequency diffusion sheet, and has an opening portion penetrating in a thickness direction of the electromagnetic wave shielding layer.
(2) The high frequency diffusion sheet according to (1), in which the electromagnetic wave shielding layer shields electromagnetic waves by reflecting or absorbing the electromagnetic waves.
(3) The high frequency diffusion sheet according to (2), in which the electromagnetic wave shielding layer is a thin metal film layer or a metal-powder-containing adhesive layer configured to contain a metal powder and a binder resin.
(4) The high frequency diffusion sheet according to any one of (1) to (3), further having: a transparent resin film, in which the electromagnetic wave shielding layer is provided by being bonded to the resin film.
(5) The high frequency diffusion sheet according to any one of (1) to (4), in which the high frequency diffusion sheet is configured such that the electromagnetic waves are diffused by being diffracted by the opening portion when the electromagnetic waves are transmitted through the high frequency diffusion sheet.
(6) The high frequency diffusion sheet according to any one of (1) to (5), in which W/λ is equal to or less than 1.0 when W [mm] is an average width of the opening portion and λ [mm] is a wavelength of the electromagnetic waves.
(7) The high frequency diffusion sheet according to any one of (1) to (6), in which an average thickness T of the electromagnetic wave shielding layer is equal to or more than 0.01 um and equal to or less than 70.0 um.
(8) The high frequency diffusion sheet according to any one of (1) to (7), in which a frequency of the electromagnetic waves is equal to or more than 1 GHz and equal to or less than 80 GHz.
(9) The high frequency diffusion sheet according to any one of (1) to (8), in which the electromagnetic wave shielding layer contains a material exhibiting translucency or opaqueness and has a plurality of through-holes penetrating in the thickness direction of the electromagnetic wave shielding layer, the through-holes being formed to have a size finer than a size of the opening portion, and
   when visible light is transmitted through the through-holes, visibility is imparted to an object located on a side opposite to the high frequency diffusion sheet.
(10)The high frequency diffusion sheet according to any one of (1) to (9), in which the high frequency diffusion sheet is used by being attached to a transmissive region provided in a building and through which the electromagnetic waves are allowed to be transmitted.

### ADVANTAGEOUS EFFECTS OF INVENTION

According to the present invention, the high frequency diffusion sheet enables electromagnetic waves of a high frequency range to be reliably diffused by being diffracted at an opening portion of the high frequency diffusion sheet when the electromagnetic waves are transmitted through the high frequency diffusion sheet. Therefore, by attaching the high frequency diffusion sheet to the transmissive region, such as a window part of a building (building that houses equipment, instruments, facilities, and the like), through which electromagnetic waves are allowed to be transmitted, the electromagnetic waves can be reliably diffused by the above-mentioned diffraction when the electromagnetic waves are transmitted through the transmissive region to which the high frequency diffusion sheet is attached, even in the case of the electromagnetic waves of the high frequency range. This enables a communication device to favorably receive the electromagnetic waves over a wide area inside a building.

### BRIEF DESCRIPTION OF THE DRAWINGS

Fig. 1 is a plan view showing a first embodiment of a high frequency diffusion sheet of the present invention.
Fig. 2 is a cross-sectional view taken along the line A-A shown in Fig. 1.
Fig. 3 is a plan view showing another configuration of opening portions in electromagnetic wave shielding layer of the high frequency diffusion sheet of Fig. 1.
Figs. 4A and 4B are plan views showing a second embodiment of the high frequency diffusion sheet of the present invention.
Figs. 5A and 5B are diagrams showing a test sample used for evaluation of diffraction of electromagnetic waves (Fig. 5A being a plan view, and Fig. 5B being a cross-sectional view taken along the line B-B of Fig. 5A).

### DESCRIPTION OF EMBODIMENTS

Hereinbelow, a high frequency diffusion sheet of the present invention will be described in detail based on suitable embodiments shown in the accompanying drawings.

### <High frequency diffusion sheet: first embodiment>

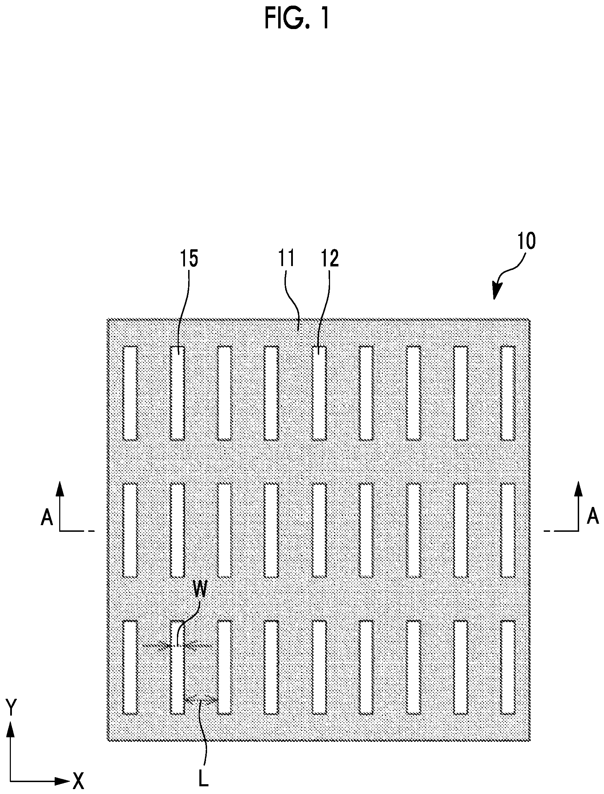

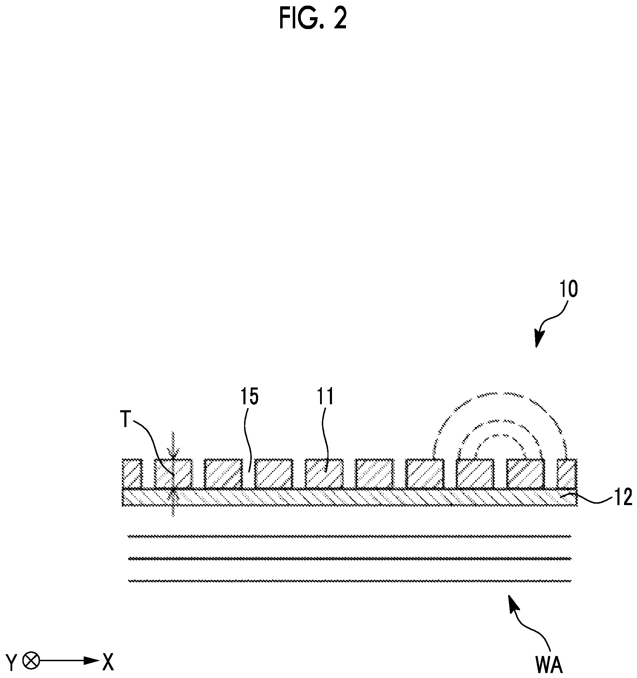

Fig. 1 is a plan view showing the first embodiment of a high frequency diffusion sheet of the present invention. Fig. 2 is a cross-sectional view taken along the line A-A shown in Fig. 1. In the following description, in Fig. 1, the front side of the paper surface will be referred to as "upper", and the back side of the paper surface will be referred to as "lower", and in Fig. 2, the upper side will be referred to as "upper", and the lower side will be referred to as "lower". In addition, in Figs. 1 and 2, the vertical direction will be referred to as a Y direction, and the horizontal direction will be referred to as an X direction. Furthermore, in each drawing referred to in the present specification, each of the dimensions in the horizontal direction and/or the thickness direction is exaggerated and is greatly different from the actual dimensions.

A high frequency diffusion sheet 10 of the present invention is used for diffusing electromagnetic waves of a high frequency range and has an electromagnetic wave shielding layer 11 having electromagnetic wave shielding properties. The electromagnetic wave shielding layer 11 is patterned when seen in a plan view of the high frequency diffusion sheet 10, and has opening portions 15 penetrating in a thickness direction of the electromagnetic wave shielding layer 11.

When the high frequency diffusion sheet 10 has such a configuration, that is, when the electromagnetic wave shielding layer 11 having electromagnetic wave shielding properties has the opening portions 15 penetrating in the thickness direction, the electromagnetic waves of the high frequency range can be diffused by being reliably diffracted at the opening portions 15 when these electromagnetic waves are transmitted through the high frequency diffusion sheet 10. Therefore, by attaching the high frequency diffusion sheet 10 to the transmissive region, such as a window part of a building (building that houses equipment, instruments, facilities, and the like), through which electromagnetic waves are allowed to be transmitted, the electromagnetic waves can be reliably diffused by diffracting the electromagnetic waves at the opening portions 15 when the electromagnetic waves are transmitted through the transmissive region to which the high frequency diffusion sheet 10 is attached, even in the case of the electromagnetic waves of the high frequency range. This enables a communication device to favorably receive the electromagnetic waves over a wide area inside a building.

In addition to the above-mentioned case of directly attaching the high frequency diffusion sheet 10 to window parts of a building (building that houses equipment, instruments, facilities, and the like), also by attaching to curtains, blinds, and the like disposed in accordance with those window parts, the high frequency diffusion sheet 10 can diffuse electromagnetic waves when the electromagnetic waves are transmitted through the window parts.

Hereinbelow, the high frequency diffusion sheet 10 having the electromagnetic wave shielding layer 11 having the opening portions 15 will be described.

In the present embodiment, the high frequency diffusion sheet 10 has the electromagnetic wave shielding layer 11 having electromagnetic wave shielding properties, and a resin film 12 supporting this electromagnetic wave shielding layer 11, as shown in Figs. 1 and 2.

### <<Resin film>>

The high frequency diffusion sheet 10 has the resin film 12 which is provided to be bonded to the electromagnetic wave shielding layer 11 to support the electromagnetic wave shielding layer 11 and which maintains the stability of the shape as the high frequency diffusion sheet 10. A resin film having transparency is preferably used.

Examples of the resin film 12 include thermosetting resins such as polyimide resin, polyamide resin, and epoxy resin; polyester resins such as polyethylene terephthalate and polyethylene naphthalate; olefin resins such as polypropylene and cycloolefin polymers; acrylic resins such as polymethyl methacrylate; and resins composed of thermoplastic resins such as polycarbonate resins as a main material. These resins are preferably used because they have transparency.

The average thickness of the resin film 12 is not particularly limited, but is preferably equal to or more than 0.01 mm and equal to or less than 0.40 mm, and more preferably equal to or more than 0.10 mm and equal to or less than 0.30 mm. By setting the average thickness of the resin film 12 within such a range, the electromagnetic wave shielding layer 11 can be reliably supported by the resin film 12.

### <<Electromagnetic wave shielding layer>>

The electromagnetic wave shielding layer 11 has the opening portions 15 penetrating in the thickness direction thereof, and is laminated on the resin film 12 while the overall shape forms a layer. The electromagnetic wave shielding layer 11 has electromagnetic wave shielding properties that suppress or shields the transmission of electromagnetic waves in the region where the opening portions 15 are not formed, and has a function of allowing electromagnetic waves to be transmitted in the region where the opening portions 15 are formed.

This electromagnetic wave shielding layer 11 is not particularly limited and may be one in any form that shields electromagnetic waves in the region where the opening portions 15 are not formed. Examples thereof include a reflective layer that shields (blocks) electromagnetic waves incident on the electromagnetic wave shielding layer 11 by preferentially reflection, and an absorption layer that shields (blocks) electromagnetic waves incident on the electromagnetic wave shielding layer 11 by preferentially absorption. Among these, the electromagnetic wave shielding layer 11 is preferably a reflective layer. Thus, the electromagnetic waves incident on the electromagnetic wave shielding layer 11 can be shielded by preferentially reflecting the electromagnetic waves, which makes it possible to improve the transmittance of the electromagnetic waves transmitted through the opening portions 15.

As described above, the electromagnetic wave shielding layer 11 may shield incident electromagnetic waves by any of reflection or absorption of the electromagnetic waves. In the present specification, a layer that shields electromagnetic waves by preferentially reflection among reflection and absorption is referred to as a reflective layer, and a layer that shields electromagnetic waves by preferentially absorption among reflection and absorption is referred to as an absorption layer.

Hereinbelow, each of the reflective layer and the absorption layer will be described.

The reflective layer shields electromagnetic waves incident on the reflective layer by preferentially reflection.

Examples of the reflective layer include a metal powder-containing adhesive layer, a thin metal film layer, a metal mesh, and a surface treatment of a conductive material such as ITO. These may be used alone or in combination. Among these, the metal powder-containing adhesive layer and the thin metal film layer are preferably used. The metal powder-containing adhesive layer and the thin metal film layer exhibit excellent electromagnetic wave shielding properties even when the film thickness (thickness) thereof is set to be relatively thin, and thus are preferably used as the reflective layer.

The metal powder-containing adhesive layer is configured to contain a metal powder and a binder resin, and examples of the metal powder include gold, silver, copper, silver-coated copper, and nickel. Among these, silver is preferably used because it is excellent in electromagnetic wave shielding properties.

The content ratio of the metal powder and the binder resin in the metal powder-containing adhesive layer is not particularly limited, but is preferably 40:60 to 95:5 in weight ratio, and is more preferably 50:50 to 90:10.

The metal powder-containing adhesive layer may further contain a flame retardant, a leveling agent, a viscosity adjuster, or the like in addition to the metal powder and the binder resin.

Examples of the thin metal film layer include vapor-deposited films and metal foils which are composed of, as a main material, the metals exemplified for the metal powder contained in the metal powder-containing adhesive layer.

The absorption layer absorbs the electromagnetic waves incident on the absorption layer to shield them from being converted into thermal energy preferentially.

Examples of the absorption layer include a conductive absorption layer composed of, as a main material, a conductive absorption material such as a metal powder and a conductive polymer material; a dielectric absorption layer composed of, as a main material, a dielectric absorption material such as a carbon material and a conductive polymer material; and a magnetic absorption layer composed of, as a main material, a magnetic absorption material such as a soft magnetic metal. These may be used alone or in combination, and a layer configured to contain these main materials and a binder resin is preferably used.

The conductive absorption layer absorbs electromagnetic waves by converting electromagnetic energy into thermal energy by the current flowing inside the material when an electric field is applied. The dielectric absorption layer absorbs electromagnetic waves by converting the electromagnetic waves into thermal energy through dielectric loss. The magnetic absorption layer absorbs electromagnetic waves by converting the energy of radio waves into heat and consuming it by magnetic losses such as overcurrent loss, hysteresis loss, and magnetic resonance.

Examples of the conductive absorption material include conductive polymers, metal oxides such as ATO, and conductive ceramics.

Furthermore, examples of the conductive polymers include polyacetylene, polypyrrole, PEDOT (poly-ethylenedioxythiophene), PEDOT/PSS, polythiophene, polyaniline, poly(p-phenylene), polyfluorene, polycarbazole, polysilane, and derivatives thereof. One or two or more of these can be used in combination.

Examples of the dielectric absorption material include carbon materials, conductive polymers, and ceramic materials.

Furthermore, examples of the carbon materials include carbon nanotubes such as single-walled carbon nanotubes and multi-walled carbon nanotubes, carbon nanofibers, CN nanotubes, CN nanofibers, BCN nanotubes, BCN nanofibers, graphene, and carbon such as carbon microcoils, carbon nanocoils, carbon nanohorns, and carbon nanowalls. One or two or more of these can be used in combination.

Examples of the ceramic materials include barium titanate, perovskite-type barium zirconate titanate calcium crystal particles, titania, alumina, zirconia, silicon carbide, and aluminum nitride. One or two or more of these can be used in combination.

Furthermore, examples of the magnetic absorption material include iron, silicon steel, magnetic stainless steel (Fe-Cr-Al-Si alloy), Sendust (Fe-Si-Al alloy), permalloy (Fe-Ni alloy), silicon copper (Fe-Cu-Si alloy), Fe-Si alloy, soft magnetic metals such as Fe-Si-B (-Cu-Nb) alloys, and ferrites.

In addition, when the absorption layer and the absorption layer contain a binder resin, this binder resin is not particularly limited, and various resin materials can be used. Examples thereof include thermosetting resins such as epoxy resins, phenolic resins, amino resins, unsaturated polyester resins, and thermosetting elastomers; and thermoplastic resins such as olefin resins, polyamide resins, polyimide resins, acrylic resins, polyester resins, vinyl chloride resins, styrene resins, and thermoplastic elastomers such as styrene thermoplastic elastomers and olefin thermoplastic elastomers. One or more of these can be used in combination.

The average thickness of the reflective layer and the absorption layer, that is, the average thickness T of the electromagnetic wave shielding layer 11 is not particularly limited, but is preferably equal to or more than 0.01 um and equal to or less than 70.0 um, more preferably equal to or more than 1.0 um and equal to or less than 70.0 um, and further preferably equal to or more than 10.0 um and equal to or less than 40.0 um. By setting the average thickness T of the electromagnetic wave shielding layer 11 within such a range, the transmission of electromagnetic waves is reliably suppressed or shielded in the region where the opening portions 15 are not formed, which makes it possible to reliably diffract, at the opening portions 15, electromagnetic waves transmitted through these opening portions 15.

As shown in Figs. 1 and 2, the opening portions 15 are through-holes that penetrate in the thickness direction of the electromagnetic wave shielding layer 11.

By providing such opening portions 15, for example, when electromagnetic waves (plane waves WA) in a high frequency range (frequency: about equal to or more than 1 GHz and equal to or less than 80 GHz) are incident on the electromagnetic wave shielding layer 11, the electromagnetic waves are diffracted at these opening portions 15 and diffused when the electromagnetic waves are transmitted through the electromagnetic wave shielding layer 11 through these opening portions 15. Accordingly, by attaching the high frequency diffusion sheet 10 to the transmissive region, such as a window part of a building (building that houses equipment, instruments, facilities, and the like), through which electromagnetic waves are allowed to be transmitted, this enables a communication device to favorably receive the electromagnetic waves in a high frequency range in a wide area inside the building (refer to Fig. 2).

The width W of the opening portions 15 is preferably set to be equal to or less than the wavelength of the electromagnetic waves transmitted through the opening portions 15. In other words, regarding the width W of the opening portions 15, when the wavelength of the electromagnetic waves is λ [mm], W/λ is preferably equal to or less than 1.0, and preferably equal to or less than 0.8. Thus, when electromagnetic waves are transmitted through the electromagnetic wave shielding layer 11, the electromagnetic waves can be diffused by being diffracted more reliably by the opening portions 15. In addition, W/λ is preferably equal to or more than 0.3, and more preferably equal to or more than 0.5. Thus, when electromagnetic waves are transmitted through the electromagnetic wave shielding layer 11, the electromagnetic waves can be diffused by being diffracted more reliably by the opening portions 15.

As shown in Fig. 1, in the present embodiment, the number of the opening portions 15 having such a configuration is not limited in the electromagnetic wave shielding layer 11. In the present embodiment, nine rows are disposed at equal intervals along an X direction (lateral direction of the opening portions 15), three rows are disposed at equal intervals along a Y direction (longitudinal direction of the opening portions 15), and a total of 27 portions (plurality) are formed.

The separated distances L between the opening portions 15 adjacent in the X direction are the same as each other. Furthermore, in the present embodiment, each of the opening portions 15 has a long shape, that is, a rectangular shape that extends linearly along the Y direction (longitudinal direction of the opening portions 15). The lengths are the same as each other, and the widths W are also the same as each other.

When the wavelength of the electromagnetic waves is λ [mm], regarding the separated distance L, L/λ is preferably equal to or more than 0.2 and equal to or less than 1.3, and more preferably equal to or more than 0.4 and equal to or less than 1. This enables uniform diffusion by the interference between the electromagnetic waves emitted from the opening portions 15.

By disposing and shaping each of the opening portions 15 as described above, the electromagnetic waves of the high frequency range can be uniformly diffracted by the opening portions 15 in the electromagnetic wave shielding layer 11.

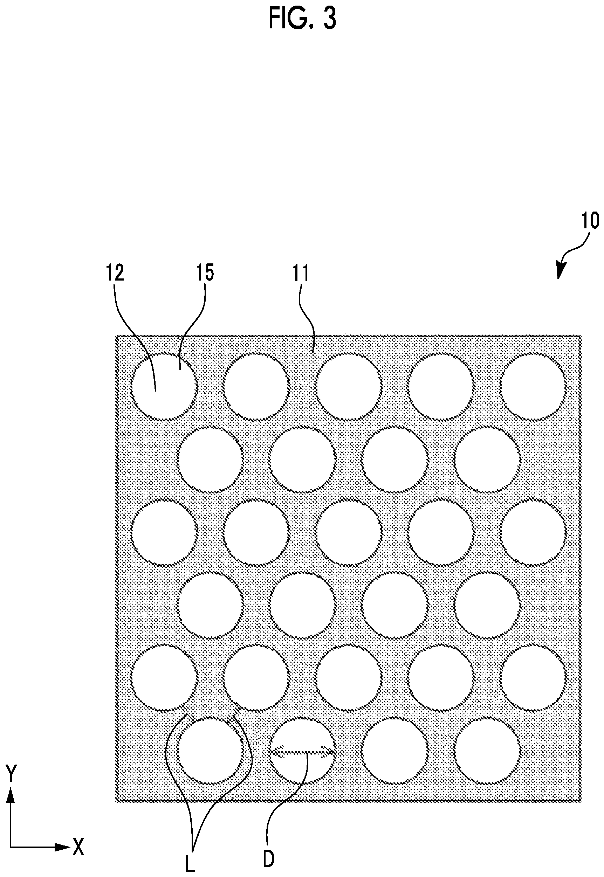

The shape of each of the opening portions 15 is a rectangular shape, that is, a linear shape when seen in a plan view, but is not limited thereto as long as the width W is set to be smaller than the wavelength of the electromagnetic waves. Examples of other shapes of the opening portions 15 include curved shapes such as a S shape, a U shape, a semi-circular shape, and a wave shape; and shapes having corner portions such as a V shape, an X shape, an L shape, an H shape, a T shape, a W shape, and an open-box shape, in addition to the case of forming a circular shape as shown in Fig. 3. Furthermore, when the shape of the opening portions 15 is a circular shape as shown in Fig. 3 when seen in a plan view, the diameter D of the circle corresponds to the width W when the shape of the opening portions 15 is a rectangular shape. Furthermore, the shortest distance between adjacent circles is handled in the same manner as the separated distance L between the opening portions 15 adjacent in the X direction when the shape of the opening portions 15 is a rectangular shape.

In addition, in the present embodiment, the case in which the opening portions 15 having the same shape are formed in the electromagnetic wave shielding layer 11 at equal intervals has been described. However, there is no limitation, and each of the opening portions 15 may have shapes different from each other or may be randomly disposed on the electromagnetic wave shielding layer 11. Furthermore, the opening portions 15 is not limited to the case in which the electromagnetic wave shielding layer 11 has a plurality thereof, and the electromagnetic wave shielding layer 11 may have at least one thereof.

### <<Pressure-sensitive adhesive layer>>

In addition, the high frequency diffusion sheet 10 may have a pressure-sensitive adhesive layer laminated on the surface of the resin film 12 on the side opposite to the electromagnetic wave shielding layer 11. This makes it possible to easily attach the high frequency diffusion sheet 10 to the transmissive region, such as a window part of a building (building that houses equipment, instruments, facilities, and the like), through which electromagnetic waves are allowed to be transmitted.

This pressure-sensitive adhesive layer is not particularly limited, but is preferably mainly composed of at least one pressure-sensitive adhesive among an acrylic pressure-sensitive adhesive, a silicone pressure-sensitive adhesive, a rubber pressure-sensitive adhesive, and the like.

Examples of the acrylic pressure-sensitive adhesive include resins composed of (meth)acrylic acid and esters thereof, and copolymers of (meth)acrylic acid and esters thereof and unsaturated monomers (such as vinyl acetate, styrene, and acrylonitrile) copolymerizable therewith. Examples thereof further include a mixture in which two or more of these resins are mixed.

Examples of the rubber pressure-sensitive adhesive include natural rubber-based, isoprene rubber-based, styrene-butadiene-based, recycled rubber-based, polyisobutylene-based pressure-sensitive adhesives, and pressure-sensitive adhesives mainly composed of block copolymers containing rubber such as styreneisoprene-styrene and styrene-butadiene-styrene.

Furthermore, examples of silicone pressure-sensitive adhesives include dimethylsiloxane-based and diphenylsiloxane-based pressure-sensitive adhesives.

In addition, various additives such as plasticizers, tackifiers, thickeners, fillers, anti-aging agents, preservatives, mildew-proofing agents, dyes, and pigments may be added to the pressure-sensitive adhesive layer as necessary.

In the present embodiment, the case in which the high frequency diffusion sheet 10 has one resin film 12 on one surface side of the electromagnetic wave shielding layer 11 has been described. However, there is no limitation. The resin film 12 may be provided on both of one surface side and the other surface side of the electromagnetic wave shielding layer 11, or alternatively, the resin film 12 may not be formed.

Furthermore, the high frequency diffusion sheet 10 may further have an interlayer and the like on at least between the electromagnetic wave shielding layer 11 and the resin film 12, and between the resin film 12 and the pressure-sensitive adhesive layer.

### <Second embodiment>

Next, the second embodiment of the high frequency diffusion sheet of the present invention will be described.

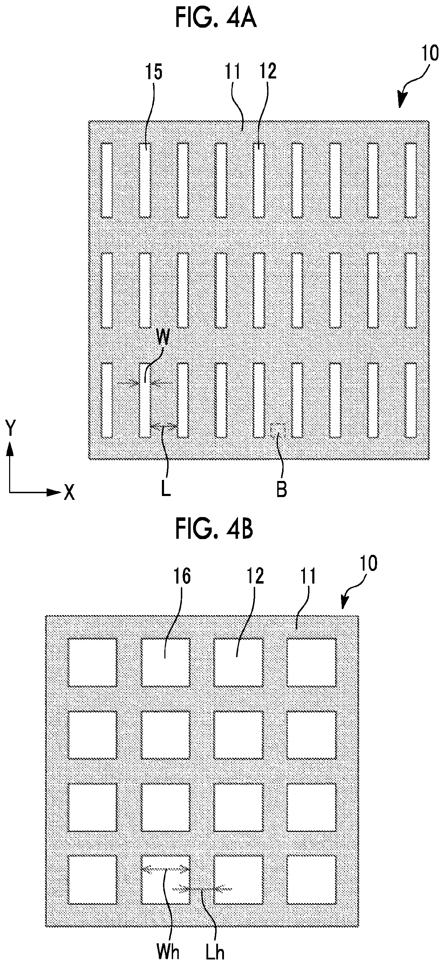

Figs. 4A and 4B are plan views showing a second embodiment of the high frequency diffusion sheet of the present invention. Fig. 4A is an overall view of the high frequency diffusion sheet of the second embodiment. Fig. 4B is a partially enlarged plan view of the high frequency diffusion sheet located in the region [B] enclosed by the dotted line in Fig. 4A.

Hereinafter, the high frequency diffusion sheet 10 of the second embodiment will be described with a focus on the differences from the high frequency diffusion sheet 10 of the first embodiment, and the description of the same features will not be repeated.

A high frequency diffusion sheet 10 shown in Figs. 4A and 4B is the same as the high frequency diffusion sheet 10 of the first embodiment shown in Fig. 1 except that the configuration of an electromagnetic wave shielding layer 11 of the high frequency diffusion sheet 10 is different.

In other words, in the high frequency diffusion sheet 10 of the second embodiment, in the region where the opening portions 15 are not formed, that is, in the region that suppresses or shields the transmission of electromagnetic waves, the electromagnetic wave shielding layer 11 has a plurality of through-holes 16 penetrating in the thickness direction of the electromagnetic wave shielding layer 11, the through-holes being formed to have a size finer than a size of the opening portion 15.

As described above, the high frequency diffusion sheet 10 of the present invention is used by being attached to the transmissive region, such as a window part of a building (building that houses equipment, instruments, facilities, and the like), through which electromagnetic waves are allowed to be transmitted. However, transparency may be required for this transmissive region such as a window part.

In addition, in the high frequency diffusion sheet 10, in the region where the opening portions 15 are not formed, the electromagnetic wave shielding layer 11 contains a material that exhibits electromagnetic wave blocking properties as a main material to suppress or shield the transmission of electromagnetic waves. However, this material exhibiting electromagnetic wave blocking properties may exhibit translucency or opaqueness.

Therefore, even when the electromagnetic wave shielding layer 11 contains the material exhibiting translucency or opaqueness, in the present embodiment, in the region where the opening portions 15 are not formed, the electromagnetic wave shielding layer 11 has a plurality of the through-holes 16 penetrating in the thickness direction thereof and formed to have a size finer than a size of the opening portions 15, in order to impart transparency to the high frequency diffusion sheet 10. This allows the transmission of visible light through the through-holes 16 even when the electromagnetic wave shielding layer 11 contains the material exhibiting translucency or opaqueness, which makes it possible to reliably impart transparency to the electromagnetic wave shielding layer 11, that is, the high frequency diffusion sheet 10.

The through-holes 16 may have any shape and size as long as they are formed to have a size finer than a size of the opening portions 15 to allow the transmission of visible light while suppressing the transmission of electromagnetic waves. However, as shown in Fig. 4B, in the case of a square shape, the width Wh of the through-holes 16 is specifically preferably about equal to or more than 50 um and less than 1,000 um, and is more preferably about equal to or more than 100 um and equal to or less than 250 um. Furthermore, in this case, the separated distance Lh between the through-holes 16 is preferably about equal to or more than 10 um and equal to or less than 150 um, and more preferably about equal to or more than 30 um and equal to or less than 75 um, for example. By setting each of the width Wh and the separated distance Lh of the square-shaped through-holes 16 within the above-mentioned ranges, the through-holes 16 can allow the transmission of visible light while reliably suppressing the transmission of electromagnetic waves.

As shown in Fig. 4B, in the present embodiment, the shape of each of the through-holes 16 forms a square shape when seen in a plan view, but the shape is not limited to this shape. Examples of other shapes of the through-holes 16 include curved shapes such as a S shape, a U shape, a circular shape, a semi-circular shape, and a wave shape; and shapes having corner portions such as a linear shape, a V shape, an X shape, an L shape, an H shape, a T shape, a W shape, and an open-box shape.

In addition, in the present embodiment, the case in which the through-holes 16 having the same shape are formed in the electromagnetic wave shielding layer 11 at equal intervals has been described. However, there is no limitation, and each of the through-holes 16 may have shapes different from each other or may be randomly disposed on the electromagnetic wave shielding layer 11.

The same effects as those of the first embodiment is also obtained with such a high frequency diffusion sheet 10 of the second embodiment.

The dimensions of each part are the same as those of the high frequency diffusion sheet 10 of the first embodiment.

In the high frequency diffusion sheet 10 of the second embodiment, which has the through-holes 16 configured as described above, the light transmittance of visible light at a wavelength of equal to or more than 300 nm and equal to or less than 800 nm is preferably equal to or more than 70% and equal to or less than 100%, and more preferably equal to or more than 90% and equal to or less than 100%. Thus, the high frequency diffusion sheet 10 can be said to have excellent light-transmitting properties, and when the high frequency diffusion sheet 10 is attached to window parts, it is possible to accurately suppress or prevent a decrease in the efficiency of taking in light from the window parts into the interior of a building (building that houses equipment, instruments, facilities, and the like). The light transmittance can be measured by an ultraviolet-visible spectrophotometer, for example.

Although the high frequency diffusion sheet of the present invention has been described above, the present invention is not limited thereto.

For example, in the high frequency diffusion sheet of the present invention, each configuration can be replaced with an arbitrary one that can exhibit similar functions, or alternatively, an arbitrary configuration can be added.

### [Examples]

Hereinbelow, the present invention will be described more specifically based on examples. The present invention is not limited at all by these examples.

### 1. Examination of diffuseness of electromagnetic waves by high frequency diffusion sheet

### 1-1. Preparation of film and the like

### <Metal-foil-laminated resin film>

An aluminum foil with an average thickness of 12 um was bonded to a PET substrate (resin film 12) with an average thickness of 0.1 mm through an acrylic adhesive, thereby preparing the aluminum foil-PET substrate laminate as a metal-foil-laminated resin film.

### <Frame>

As a frame 100 that does not allow the transmission of electromagnetic waves, a frame configured from an aluminum plate and having a square outer shape and square opening portions was prepared (outer shape: 200 mm × 200 mm, opening portion: 100 mm × 100 mm) .

### 1-2. Production of high frequency diffusion sheet

### (Sample No. 1A)

The prepared metal-foil-laminated resin film (aluminum foil-PET substrate laminate) was cut into a size of 100 mm × 100 mm. Thereafter, the aluminum foil of this metal-foil-laminated resin film was irradiated with a laser to form an electromagnetic wave shielding layer 11 on a resin film 12 by providing, on the aluminum foil, a total of ten opening portions 15 (slit) having length 90 mm × width W 5 mm and having a separated distance L (interval) of 5 mm, thereby producing a high frequency diffusion sheet 10 of a sample No. 1A.

### (Sample Nos. 2A to 10A)

High frequency diffusion sheets 10 of sample Nos. 2A to 10A were produced in the same manner as in the above-mentioned sample No. 1A except that at least one of the length and the width W of the opening portions 15 formed on the aluminum foil, the separated distance L between the opening portions 15, and the number of the opening portions 15 was changed as shown in Table 1.

### (Sample No. 11A)

A high frequency diffusion sheet 10 of a sample No. 11A was prepared by not forming the opening portions 15 on the aluminum foil.

### 1-3. Evaluation

### <Confirmation of diffuseness of electromagnetic waves>

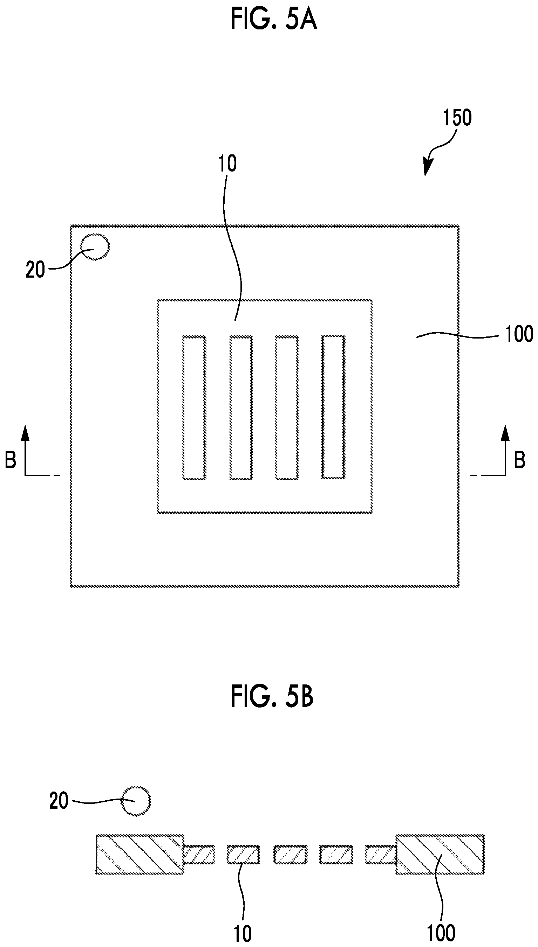

<1A> First, the high frequency diffusion sheets 10 of each of the sample numbers were mounted on the frame 100 so as to correspond to the opening portions provided on the frame 100, thereby obtaining a test sample 150 for confirming diffraction of electromagnetic waves (refer to Figs. 5A and 5B).
<2A> Subsequently, as shown in Figs. 5A and 5B, a receiver 20 was disposed such that the receiver was 10 mm inward in the plane direction from the end part of the frame 100, and the separated distance in the thickness direction from the frame 100 was 10 mm.
<3A> Subsequently, electromagnetic waves (plane waves) with a frequency of 28 GHz were incident on the high frequency diffusion sheets 10 of each of the sample numbers from the surface of the test sample 150 on the opposite side on which the receiver 20 was disposed. Thereafter, the electromagnetic waves transmitted through the high frequency diffusion sheet 10 were received using the receiver 20. Then, the presence or absence of diffraction (diffusion) of the electromagnetic waves by the high frequency diffusion sheet 10 was evaluated based on the following evaluation criteria.

### [Evaluation criteria]

A: the electromagnetic waves could be clearly received by the receiver 20.
B: the electromagnetic waves could be sufficiently received by the receiver 20 although the reception could not be said to be clear.
C: the electromagnetic waves could be received by the receiver 20 although the reception intensity could not be said to be sufficient.
D: the reception intensity was an intensity that could not be said that the electromagnetic waves could be received by the receiver 20.

Table 1 below shows each of the evaluation results obtained as described above.

**[Table 1]**

| | | Examples | | | | | | | | | | Comparative Example |
|---|---|---|---|---|---|---|---|---|---|---|---|---|
| Examination of electromagnetic waves with frequency of 28 GHz (wavelength of 10.7 mm) | | Sample Nos. | | | | | | | | | | |
| | | 1A | 2A | 3A | 4A | 5A | 6A | 7A | 8A | 9A | 10A | 11A |
| Opening portion 15 | Shape | Rectangular shape | | | | | | | | | | Not formed |
| | Length [mm] | 90 | | | | | | | | | | - |
| | Width W [mm] | 5 | | | 7.5 | | | 10 | | | 20 | - |
| | Separated distance L [mm] | 5 | 7.5 | 10 | 5 | 7.5 | 10 | 5 | 7.5 | 10 | 5 | |
| | Number of opening portions 15 | 10 | 8 | 7 | 8 | 7 | 5 | 7 | 5 | 5 | 4 | - |
| Evaluation | Presence or absence of diffraction of electromagnetic waves | B | C | C | A | B | B | B | C | C | C | D |

As shown in Table 1, the results show that, when the electromagnetic wave shielding layer 11 provided in the high frequency diffusion sheet 10 has the opening portions 15 penetrating in the thickness direction, electromagnetic waves were diffused by being diffracted by the opening portions 15 of the electromagnetic wave shielding layer 11 when the electromagnetic waves were transmitted through the high frequency diffusion sheet 10. Furthermore, it became clear that the electromagnetic waves could be diffused with better diffuseness by setting the width W of the opening portions 15 to be smaller than the wavelength of the electromagnetic waves and by appropriately setting the separated distance L between the opening portions 15.

### 2. Examination of transmittance of visible light in high frequency diffusion sheet

### 2-1. Preparation of film and the like

### <Metal-foil-laminated resin film>

An aluminum foil with an average thickness of 12 um was bonded to a PET substrate (resin film 12) with an average thickness of 0.1 mm through an acrylic adhesive, thereby preparing the aluminum foil-PET substrate laminate as a metal-foil-laminated resin film.

### <Frame>

As a frame 100 that does not allow the transmission of electromagnetic waves, a frame configured from an aluminum plate and having a square outer shape and square opening portions was prepared (outer shape: 200 mm × 200 mm, opening portion: 100 mm × 100 mm) .

### 2-2. Production of high frequency diffusion sheet

### (Sample No. 1B)

The prepared metal-foil-laminated resin film (aluminum foil-PET substrate laminate) was cut into a size of 100 mm × 100 mm. Thereafter, the aluminum foil of this metal-foil-laminated resin film was irradiated with a laser to provide, on the aluminum foil, a total of ten opening portions 15 (slit) having length 90 mm × width W 5 mm and having a separated distance L (interval) of 5 mm. Thereafter, in the region where the opening portions 15 of the aluminum foil were not formed, through-holes 16 having a square shape with a width Wh of 250 um were formed in a lattice shape with a separated distance Lh of 50 µm by laser irradiation, thereby producing a high frequency diffusion sheet 10 of a sample No. 1B in which the electromagnetic wave shielding layer 11 was provided on the resin film 12.

### (Sample Nos. 2B to 9B)

High frequency diffusion sheets 10 of sample Nos. 2B to 9B were produced in the same manner as in the above-mentioned sample No. 1B except that at least one of the width W of the opening portions 15 formed on the aluminum foil and the separated distance L between the opening portions 15 was changed as shown in Table 2.

2-3. Evaluation

### <Confirmation of diffuseness of electromagnetic waves>

<1A> First, the high frequency diffusion sheets 10 of each of the sample numbers were mounted on the frame 100 so as to correspond to the opening portions provided on the frame 100, thereby obtaining a test sample 150 for confirming diffraction of electromagnetic waves (refer to Figs. 5A and 5B).
<2A> Subsequently, as shown in Figs. 5A and 5B, a receiver 20 was disposed such that the receiver was 10 mm inward in the plane direction from the end part of the frame 100, and the separated distance in the thickness direction from the frame 100 was 10 mm.
<3A> Subsequently, electromagnetic waves (plane waves) with a frequency of 28 GHz were incident on the high frequency diffusion sheets 10 of each of the sample numbers from the surface of the test sample 150 on the opposite side on which the receiver 20 was disposed. Thereafter, the electromagnetic waves transmitted through the high frequency diffusion sheet 10 were received using the receiver 20. Then, the presence or absence of diffraction (diffusion) of the electromagnetic waves by the high frequency diffusion sheet 10 was evaluated based on the following evaluation criteria.

### [Evaluation criteria]

A: the electromagnetic waves could be clearly received by the receiver 20.
B: the electromagnetic waves could be sufficiently received by the receiver 20 although the reception could not be said to be clear.
C: the electromagnetic waves could be received by the receiver 20 although the reception intensity could not be said to be sufficient.
D: the reception intensity was an intensity that could not be said that the electromagnetic waves could be received by the receiver 20.

### <Confirmation of transmittance of visible light>

For the high frequency diffusion sheets 10 of each of the sample numbers, the light transmittance (%) of visible light at a wavelength of equal to or more than 300 nm and equal to or less than 800 nm was measured using an ultraviolet-visible spectrophotometer ("UV-2600i" manufactured by Shimadzu Corporation). Then, the presence or absence of transmission of visible light by the high frequency diffusion sheet 10 was evaluated based on the following evaluation criteria.

### [Evaluation criteria]

The light transmittance of visible light at a wavelength of equal to or more than 300 nm and equal to or less than 800 nm was as follows.
A: equal to or more than 70%.
B: equal to or more than 50% and less than 70%.
C: less than 50%.

Table 2 below shows each of the evaluation results obtained as described above.

**[Table 2]**

| | | Examples | | | | | | | | |
|---|---|---|---|---|---|---|---|---|---|---|
| Examination of electromagnetic waves with frequency of 28 GHz (wavelength of 10.7 mm) | | Sample Nos. | | | | | | | | |
| | | 1B | 2B | 3B | 4B | 5B | 6B | 7B | 8B | 9B |
| Opening portion 15 | Shape | Rectangular shape | | | | | | | | |
| | Length [mm] | 90 | | | | | | | | |
| | Width W [mm] | 5 | | | 7.5 | | | 10 | | |
| | Separated distance L [mm] | 5 | 7.5 | 10 | 5 | 7.5 | 10 | 5 | 7.5 | 10 |
| | Number of opening portions 15 | 10 | 8 | 7 | 8 | 7 | 5 | 7 | 5 | 5 |
| Evaluation | Presence or absence of diffraction of electromagnetic waves | B | C | C | A | B | B | B | C | C |
| | Presence or absence of transmission of visible light | A | A | A | A | A | A | A | A | A |

As shown in Table 2, the results show that, when the electromagnetic wave shielding layer 11 provided in the high frequency diffusion sheet 10 has the opening portions 15 penetrating in the thickness direction, electromagnetic waves were diffused by being diffracted by the opening portions 15 of the electromagnetic wave shielding layer 11 when the electromagnetic waves were transmitted through the high frequency diffusion sheet 10. In the sample Nos. 1B to 9B, the diffractiveness of the electromagnetic waves by the opening portions 15 showed a similar tendency as that of the sample Nos. 1A to 10A in Table 1 in which the through-holes 16 were not formed in the region where the opening portions 15 of the electromagnetic wave shielding layer 11 were not formed. Therefore, it was found that electromagnetic waves could be diffracted (diffused) at the opening portions 15 even when the through-holes 16 were formed in the region where opening portions 15 of the electromagnetic wave shielding layer 11 were not formed.

It was also clarified that the transmittance of visible light could be imparted to the high frequency diffusion sheet 10 by forming the through-holes 16 in the region where the opening portions 15 of the electromagnetic wave shielding layer 11 were not formed.

### 3. Examination of diffuseness and transmittance in opening portions with different lengths

### 3-1. Preparation of frame

### <Frame>

As the frame 100 that does not allow the transmission of electromagnetic waves, a frame configured from an aluminum plate and having a square outer shape and square opening portions was prepared (outer shape: 600 mm × 600 mm, opening portion: 300 mm × 300 mm) .

### 3-2. Production of high frequency diffusion sheet

### (Sample No. 1C)

A PET substrate (resin film 12) melted by heating was laminated on a copper foil having an average thickness of 12 um to prepare a copper foil-PET substrate laminate as a metal-foil-laminated resin film. The prepared metal-foil-laminated resin film was cut into a size of 600 mm × 600 mm. Thereafter, a photosensitive film mask was laminated on the copper foil surface of the metal-foil-laminated resin film to perform exposure patterning and a development treatment. After the development, the copper foil was patterned with a metal etchant. An electromagnetic wave shielding layer 11 was formed on the resin film 12 by providing, on the copper foil, a total of 23 opening portions 15 (slit) having length 300 mm × width W 7 mm and having a separated distance L (interval) of 6 mm, thereby producing a high frequency diffusion sheet 10 of a sample No. 1C.

### (Sample No. 2C)

A copper foil with an average thickness of 12 um was bonded to a PET substrate (resin film 12) with an average thickness of 0.1 mm through an acrylic adhesive, thereby preparing the copper foil-PET substrate laminate as a metal-foil-laminated resin film. The prepared metal-foil-laminated resin film was cut into a size of 600 mm × 600 mm. Thereafter, a photosensitive film mask was laminated on the copper foil surface of the metal-foil-laminated resin film to perform exposure patterning and a development treatment. After the development, the copper foil was patterned with a metal etchant. An electromagnetic wave shielding layer 11 was formed on the resin film 12 by providing, on the copper foil, a total of 23 opening portions 15 (slit) having length 300 mm × width W 7 mm and having a separated distance L (interval) of 6 mm, thereby producing a high frequency diffusion sheet 10 of a sample No. 2C.

### (Sample No. 3C)

A PET substrate (resin film 12) having an average thickness of 0.1 mm was cut into a size of 600 mm × 600 mm. Thereafter, 50 nm copper vapor deposition was performed on the entire surface of this PET substrate. Thereafter, a photosensitive film mask was laminated on the copper vapor-deposited surface to perform exposure patterning and a development treatment. After the development, a metal etching treatment was performed to remove the copper of the opening portions, thereby providing copper patterning. Thereafter, the photosensitive film was removed. An electromagnetic wave shielding layer 11 was formed on the resin film 12 by providing a total of 23 opening portions 15 (slit) having length 300 mm × width W 7 mm and having a separated distance L (interval) of 6 mm, thereby producing a high frequency diffusion sheet 10 of a sample No. 3C.

### (Sample No. 4C)

A PET substrate (resin film 12) having an average thickness of 0.1 mm was cut into a size of 600 mm × 600 mm. Thereafter, a photosensitive film mask was laminated on this PET substrate to perform exposure patterning and a development treatment. After the development, a vapor-deposited layer having a thickness of 50 nm was provided in the opening portions by a copper vapor deposition treatment. The photosensitive film was removed after the vapor deposition. An electromagnetic wave shielding layer 11 was formed on the resin film 12 by providing a total of 23 opening portions 15 (slit) having length 300 mm × width W 7 mm and having a separated distance L (interval) of 6 mm, thereby producing a high frequency diffusion sheet 10 of a sample No. 4C.

### (Sample No. 5C)

A PET substrate (resin film 12) having an average thickness of 0.1 mm was cut into a size of 600 mm × 600 mm. Thereafter, 50 nm aluminum vapor deposition was performed on the entire surface of this PET substrate. Thereafter, a photosensitive film mask was laminated on the aluminum vapor-deposited surface to perform exposure patterning and a development treatment. After the development, a metal etching treatment was performed to remove the aluminum of the opening portions, thereby providing aluminum patterning. Thereafter, the photosensitive film was removed. An electromagnetic wave shielding layer 11 was formed on the resin film 12 by providing a total of 23 opening portions 15 (slit) having length 300 mm × width W 7 mm and having a separated distance L (interval) of 6 mm, thereby producing a high frequency diffusion sheet 10 of a sample No. 5C.

### (Sample No. 6C)

A PET substrate (resin film 12) having an average thickness of 0.1 mm was cut into a size of 600 mm × 600 mm. Thereafter, 50 nm aluminum vapor deposition was performed on the entire surface of this PET substrate. Thereafter, a photosensitive film mask was laminated on the aluminum vapor-deposited surface to perform exposure patterning and a development treatment. After the development, a metal etching treatment was performed to remove the aluminum of the opening portions, thereby providing aluminum patterning. Thereafter, the photosensitive film was removed. A total of 23 opening portions 15 (slit) having length 300 mm × width W 7 mm and having a separated distance L (interval) of 6 mm was provided. Furthermore, in the region where the opening portions 15 of the electromagnetic wave shielding layer 11 were not formed, the electromagnetic wave shielding layer 11 in which the square-shaped through-holes 16 having a width Wh of 250 um were formed with a separated distance Lh of 50 um was formed on the resin film 12, thereby producing a high frequency diffusion sheet 10 of a sample No. 6C.

### (Sample Nos. 7C to 11C)

High frequency diffusion sheets 10 of sample Nos. 7C to 11C were produced in the same manner as in the above-mentioned sample No. 6C except that at least one of the width W of the opening portions 15, the separated distance L between the opening portions 15, and the number of the opening portions 15 was changed as shown in Table 3.

### (Sample No. 12C)

A high frequency diffusion sheet 10 of a sample No. 12C was produced in the same manner as in the above-mentioned sample No. 5C except that the width W, the separated distance L, and the number of the opening portions were changed as shown in Table 3.

### 3-3. Evaluation

### <Confirmation of diffuseness of electromagnetic waves>

<1C> First, the high frequency diffusion sheets 10 of each of the sample numbers were mounted on the frame 100 so as to correspond to the opening portions provided on the frame 100, thereby obtaining a test sample 150 for confirming diffraction of electromagnetic waves (refer to Figs. 5A and 5B).
<2C> Subsequently, as shown in Figs. 5A and 5B, a receiver 20 was disposed such that the receiver was 10 mm inward in the plane direction from the end part of the frame 100, and the separated distance in the thickness direction from the frame 100 was 10 mm.
<3C> Subsequently, electromagnetic waves (plane waves) with a frequency shown in Table 3 were incident on the high frequency diffusion sheets 10 of each of the sample numbers from the surface of the test sample 150 on the opposite side on which the receiver 20 was disposed. Thereafter, the electromagnetic waves transmitted through the high frequency diffusion sheet 10 were received using the receiver 20. Then, the presence or absence of diffraction (diffusion) of the electromagnetic waves by the high frequency diffusion sheet 10 was evaluated based on the following evaluation criteria.

### [Evaluation criteria]

A: the electromagnetic waves could be clearly received by the receiver 20.
B: the electromagnetic waves could be sufficiently received by the receiver 20 although the reception could not be said to be clear.
C: the electromagnetic waves could be received by the receiver 20 although the reception intensity could not be said to be sufficient.
D: the reception intensity was an intensity that could not be said that the electromagnetic waves could be received by the receiver 20.

### <Confirmation of transmittance of visible light>

For the high frequency diffusion sheets 10 of each of the sample numbers, the light transmittance (%) of visible light at a wavelength of equal to or more than 300 nm and equal to or less than 800 nm was measured using an ultraviolet-visible spectrophotometer ("UV-2600i" manufactured by Shimadzu Corporation). Then, the presence or absence of transmission of visible light by the high frequency diffusion sheet 10 was evaluated based on the following evaluation criteria.

### [Evaluation criteria]

The light transmittance of visible light at a wavelength of equal to or more than 300 nm and equal to or less than 800 nm was as follows.
A: equal to or more than 70%.
B: equal to or more than 50% and less than 70%.
C: less than 50%.

Table 3 below shows each of the evaluation results obtained as described above.

**[Table 3]**

| | | Examples | | | | | | | | | | | | | Comparative Example |
|---|---|---|---|---|---|---|---|---|---|---|---|---|---|---|---|
| | | Sample Nos. | | | | | | | | | | | | | |
| | | 1C | 2C | 3C | 4C | 5C | 6C | 7C | 8C | 9C | 10C | 11C | 12C | 13C | 14C |
| Material of electromagnetic wave shielding layer 11 | Copper | ∘ | ∘ | ∘ | ∘ | | | | | | | | | | - |
| | Aluminum | | | | | ∘ | ∘ | ∘ | ∘ | ∘ | ∘ | ∘ | ∘ | ∘ | - |
| Method of forming electromagnetic wave shielding layer 11 on resin film 12 | Fusion | ∘ | | | | | | | | | | | | | - |
| | Adhesion | | ∘ | | | | | | | | | | | ∘ | - |
| | Vapor deposition | | | ∘ | ∘ | ∘ | ∘ | ∘ | ∘ | ∘ | ∘ | ∘ | ∘ | | - |
| Method of forming opening portions | Etching | ∘ | ∘ | ∘ | | ∘ | ∘ | ∘ | ∘ | ∘ | ∘ | ∘ | ∘ | | |
| | Vapor deposition patterning | | | | ∘ | | | | | | | | | | - |
| Frequency (GHz) of electromagnetic waves (plane waves) | | 28 | 28 | 28 | 28 | 28 | 28 | 28 | 28 | 28 | 28 | 28 | 4 | 28 | |
| Opening portion 15 | Shape | Rectangular shape | | | | | | | | | | | | | Not formed |
| | Length (mm) | 300 | 300 | 300 | 300 | 300 | 300 | 300 | 300 | 300 | 300 | 300 | 300 | 90 | - |
| | Width W (mm) | 7 | 7 | 7 | 7 | 7 | 7 | 5 | 7 | 5 | 10 | 10 | 49 | 5 | - |
| | Separated distance L (mm) | 6 | 6 | 6 | 6 | 6 | 6 | 6 | 10 | 10 | 6 | 10 | 42 | 5 | - |
| | (Relationship W/λ between separated distance W and X) | 0.7 | 0.7 | 0.7 | 0.7 | 0.7 | 0.7 | 0.5 | 0.7 | 0.5 | 1 | 1 | 0.7 | 0.5 | - |
| | (Relationship L/λ between separated distance L and X) | 0.6 | 0.6 | 0.6 | 0.6 | 0.6 | 0.6 | 0.6 | 1 | 1 | 0.6 | 1 | 0.6 | 0.5 | - |
| | Number of opening portions 15 | 23 | 23 | 23 | 23 | 23 | 23 | 27 | 18 | 20 | 19 | 15 | 3 | 10 | - |
| Evaluation | Diffuseness of electromagnetic waves | A | A | A | A | A | A | B | B | C | B | C | A | B | D |
| | Presence or absence of transmission of visible light | C | C | C | C | C | A | A | A | A | A | A | C | C | C |

As shown in Table 3, the results show that, when the electromagnetic wave shielding layer 11 provided in the high frequency diffusion sheet 10 has the opening portions 15 penetrating in the thickness direction, electromagnetic waves were diffused by being diffracted by the opening portions 15 of the electromagnetic wave shielding layer 11 when the electromagnetic waves were transmitted through the high frequency diffusion sheet 10. Furthermore, it became clear that the electromagnetic waves could be diffused with better diffuseness by setting the width W of the opening portions 15 to be smaller than the wavelength of the electromagnetic waves and by appropriately setting the separated distance L between the opening portions 15.

It was also clarified that the transmittance of visible light could be imparted to the high frequency diffusion sheet 10 in the case of forming the through-holes 16 in the region where the opening portions 15 of the electromagnetic wave shielding layer 11 were not formed.

### REFERENCE SIGNS LIST

10: high frequency diffusion sheet
11: electromagnetic wave shielding layer
12: resin film
15: opening portion
16: through-hole
20: receiver
100: frame
150: test sample
L: separated distance
Lh: separated distance
T: average thickness
W: width
Wh: width
WA: plane wave

According to the present invention, the high frequency diffusion sheet enables electromagnetic waves of a high frequency range to be reliably diffused by being diffracted at an opening portion of the high frequency diffusion sheet when the electromagnetic waves are transmitted through the high frequency diffusion sheet. Therefore, by attaching the high frequency diffusion sheet to the transmissive region, such as a window part of a building (building that houses equipment, instruments, facilities, and the like), through which electromagnetic waves are allowed to be transmitted, the electromagnetic waves can be reliably diffused by the above-mentioned diffraction when the electromagnetic waves are transmitted through the transmissive region to which the high frequency diffusion sheet is attached, even in the case of the electromagnetic waves of the high frequency range. This enables a communication device to favorably receive the electromagnetic waves over a wide area inside a building. Accordingly, the present invention has industrial applicability.

## Claims

1. A high frequency diffusion sheet which is used for diffusing electromagnetic waves of a high frequency range, the high frequency diffusion sheet comprising:
an electromagnetic wave shielding layer having electromagnetic wave shielding properties,
wherein the electromagnetic wave shielding layer is patterned when seen in a plan view of the high frequency diffusion sheet, and has an opening portion penetrating in a thickness direction of the electromagnetic wave shielding layer.

2. The high frequency diffusion sheet according to claim 1, wherein the electromagnetic wave shielding layer shields electromagnetic waves by reflecting or absorbing the electromagnetic waves.

3. The high frequency diffusion sheet according to claim 2, wherein the electromagnetic wave shielding layer is a thin metal film layer or a metal-powder-containing adhesive layer configured to contain a metal powder and a binder resin.

4. The high frequency diffusion sheet according to any one of claims 1 to 3, further comprising:
a transparent resin film,
wherein the electromagnetic wave shielding layer is provided by being bonded to the resin film.

5. The high frequency diffusion sheet according to any one of claims 1 to 4, wherein the high frequency diffusion sheet is configured such that the electromagnetic waves are diffused by being diffracted by the opening portion when the electromagnetic waves are transmitted through the high frequency diffusion sheet.

6. The high frequency diffusion sheet according to any one of claims 1 to 5, wherein W/λ is equal to or less than 1.0 when W [mm] is an average width of the opening portion and λ [mm] is a wavelength of the electromagnetic waves.

7. The high frequency diffusion sheet according to any one of claims 1 to 6, wherein an average thickness T of the electromagnetic wave shielding layer is equal to or more than 0.01 um and equal to or less than 70.0 um.

8. The high frequency diffusion sheet according to any one of claims 1 to 7, wherein a frequency of the electromagnetic waves is equal to or more than 1 GHz and equal to or less than 80 GHz.

9. The high frequency diffusion sheet according to any one of claims 1 to 8,
wherein the electromagnetic wave shielding layer contains a material exhibiting translucency or opaqueness and has a plurality of through-holes penetrating in the thickness direction of the electromagnetic wave shielding layer, the through-holes being formed to have a size finer than a size of the opening portion, and
when visible light is transmitted through the through-holes, visibility is imparted to an object located on a side opposite to the high frequency diffusion sheet.

10. The high frequency diffusion sheet according to any one of claims 1 to 9, wherein the high frequency diffusion sheet is used by being attached to a transmissive region provided in a building and through which the electromagnetic waves are allowed to be transmitted.
